# EUROPÄISCHE PATENTSCHRIFT

(11) **EP 1 352 551 B1**
(45) Veröffentlichungstag und Bekanntmachung des Hinweises auf die Patenterteilung: **15.09.2004**
(21) Anmeldenummer: 01909529.8
(22) Anmeldetag: 26.01.2001
(51) Int. Cl.: H05K 7/06, G06K 19/077

(54) **VERFAHREN UND VORRICHTUNG ZUM ANBRINGEN VON LEITERDRÄHTEN AUF ODER IN EINER TRAGESCHICHT**
METHOD AND DEVICE FOR PLACING CONDUCTOR WIRES ON OR IN A SUPPORTING LAYER
PROCEDE ET DISPOSITIF POUR PLACER DES FILS CONDUCTEURS SUR OU DANS UNE COUCHE DE SUPPORT

(30) Priorität: 15.01.2001 WO PCT/DE01/00150
(43) Veröffentlichungstag der Anmeldung: 15.10.2003
(73) Patentinhaber: cubit electronics GmbH, 99099 Erfurt (DE)
(72) Erfinder: MICHALK, Manfred, 99096 Erfurt (DE)
(74) Vertreter: Liedtke, Klaus, Dr.
(86) Internationale Anmeldenummer: PCT/DE2001/000323
(87) Internationale Veröffentlichungsnummer: WO 2002/056657

(56) Entgegenhaltungen:
- EP-A- 0 310 208
- DD-A- 295 499
- DE-A- 4 410 732
- DE-A- 19 525 933
- DE-A- 19 705 934
- US-A- 3 279 040
- US-A- 3 674 602
- US-A- 5 345 978

## Beschreibung

Die Erfindung betrifft ein Verfahren und eine Vorrichtung zum Anbringen von Leiterdrähten auf oder in einer Trageschicht, bei dem eine zuvor außerhalb der Trageschicht hergestellte Leiterdrahtanordnung anschließend in die Trageschicht gedrückt wird.

Die Erfindung ist sowohl geeignet zum Anbringen von Leiterbahnen auf oder in einer elektrisch isolierenden Schicht, beispielsweise zum Anbringen von Leiterdrähten in Plastikkarten, als auch auf oder in Substratbeschichtungen von Packmaterial und Etiketten. Dabei wird ein außerhalb der Trageschicht hergestelltes Leiterdrahtmuster, welches gegebenenfalls mit elektronischen Bauelementen kontaktiert ist, im allgemeinen in eine elektrisch isolierende Schicht gedrückt.

Trageschichten können dabei Papier, Pappe, Plastfolien, Tiefziehteile, Gerätewandungen oder Bauteile und dergleichen sein, die mit Selbstklebeschichten versehen sind.

Die Erfindung findet vorzugsweise Anwendung bei der Herstellung von Transpondem, insbesondere kontaktloser ticket- oder etikettenartiger Transponder, Wertpapiere, fälschungssicherer Marken und von in Geräte oder Verpackungsmittel integrierten Transpondern.
Unter Transponder wird hierbei ein Datenträger mit einem Körper, vorzugsweise mit einem Kunststoffkörper verstanden, der mindestens ein Chip enthält, welches elektrisch leitend mit mindestens einer Spule bzw. einer Antenne verbunden ist.
Bevorzugte Anwendungen sind hierfür kontaktlose Chipkarten, kontaktlose Etiketten und kontaktlose münzförmige Datenträger.

Im Stand der Technik ist es nach DE 195 25 933 A 1 bekannt, eine Windungauf-Windung gewickelte Spule aus lackisoliertem Wickeldraht herzustellen und mittels eines Wickel-Werkzeugteils in eine thermoplastische Folie einzupressen. Nachteilig ist dabei, daß mit diesem Verfahren nur einfache, spulenförmige Leiterzugmuster herstellbar sind und daß nur isolierlackbeschichteter Draht verwendet werden kann.

Nach DE 44 10 732 A 1 und US 3.674.602 sind ebenfalls Verfahren bekannt, mit denen isolierter Draht in beliebigen Mustern auf thermoplastischen Folien befestigt werden kann.
Auch bei diesen Verfahren ist nachteilig, daß isolierlackbeschichteter Draht verwendet werden muss. Außerdem belasten die zur Kontaktierung von aktiven und passiven Bauelementen erforderlichen zusätzlichen Arbeitsschritte zur Entlackung der Drähte diese Bauelemente in thermischer oder/und mechanischer Hinsicht erheblich. Weitere Nachteile sind die Begrenzung auf Folien als künftiger Schaltungsträger und die sequentielle Bearbeitung relativ großer Nutzen als Schaltungsträger.

Auch das in DE 197 05 934.1 A 1 beschriebene Verfahren weist ähnliche Nachteile auf und ist mit einer relativ hohen Temperaturbelastung der thermoplastischen Folie verbunden.

Nach US 3 279 040 ist ein Verfahren zum Installieren von Spulen für elektrische Schaltkreise bekannt, bei dem Leiterdrähte um Spannelemente gespannt und anschließend in Silikon eingebettet werden.
Ferner ist es nach DD 295 499 A5 bekannt Verdrahtungsträger unter Verwendung von Drähten herzustellen, bei denen Drähte in einer Vergußmasse fixiert werden und danach eine Trägerplatte auf die Drähte geklebt wird.
Bei diesen Verfahren ist nachteilig, daß aufwendige Arbeitsgänge erforderlich sind.

Der Erfindung liegt die Aufgabe zugrunde, ein Verfahren und eine Vorrichtung der eingangs genannten Art anzugeben, bei denen es mit einfachen Mitteln möglich ist, Leiterdrahtmuster herzustellen und Drähte sowohl mit als auch ohne Isolierlackschichten zu verarbeiten und mit elektrischen oder elektronischen Bauelementen zu kontaktieren und gegebenenfalls diese Leiterdrahtmuster untereinander und mit elektronischen Bauelementen zu verbinden und danach die gesamte so entstandene Anordnung in einer Arbeitsgangfolge gemeinsam auf oder in einer Trageschicht dauerhaft zu fixieren.

Erfindungsgemäß wird die Aufgabe mit einem Verfahren, welches die in Anspruch 1 angegebenen Merkmale und mit einer Vorrichtung, welche die in Anspruch 9 angegebenen Merkmale enthält, gelöst.

Vorteilhafte Ausgestaltungen sind in den Unteransprüchen angegeben.

Bei dem erfindungsgemäßen Verfahren werden Leiterdrähte auf einen Spannrahmen mit senkrecht oder nahezu senkrecht aus der Drückebene des Spannrahmens austretenden Spannelementen gespannt, wobei die Leiterdrähte parallel oder nahezu parallel zu einer Drückebene über die Spannelementeseitenflächen zu einem vorgegebenen Muster gespannt werden und das Leiterdrahtmuster danach mittels Druck der Drückebene des Spannrahmens auf eine oder mindestens teilweise in eine mindestens partiell elektrisch isolierende Trageschicht übertragen wird. Gegebenenfalls erfolgt zuvor ein Kontaktieren des Leiterdrahtmusters mit mindestens einem elektronischen Bauelement, so dass sich eine elektrische Schaltungsanordnung ergibt. Es erfolgt ein Eindrükken in die im allgemeinen isolierende Trageschicht, wobei die Drähte der Leiterdrahtmuster und gegebenenfalls der elektronischen Bauelemente soweit in diese Schicht eingedrückt werden, dass eine Lagefixierung gegeben ist.

Als Spannelemente können vorteilhaft zylindrische Stifte verwendet werden, die in vielfältigen Ausführungen und Abmessungen kostengünstig erhältlich sind. Vorteilhafterweise gleiten die Stifte beim Eindrücken mit der Drückbewegung zurück, fixieren aber immer die Leiterdrähte und gegebenenfalls die mit ihnen verbundenen elektronischen Bauelemente im Muster bis sie in der Schicht fixiert sind. Für die zu behandelnde Trageschicht kommen alle Materialien in Betracht, die mit Thermoplast beschichtet sind bzw. thermoplastähnliche Eigenschaften aufweisen oder die mit Selbstklebeschichten dauerhaft beschichtbar sind. Es ist vorzugsweise die Behandlung ebener Flächen vorgesehen, bedingt können aber auch auf bzw. in dreidimensional gestaltete Körper Leiterdrahtmuster auf- oder eingebracht werden.
Die Spannelemente können in ihrer Länge gestuft sein, damit das Aufspannen der Drahtmuster auf dem Spannrahmen mit hoher Produktivität manuell oder mittels Roboter oder anderen Mitteln möglich ist.

Vorteilhaft ist, daß viele Drahtsorten verwendbar sind, ohne daß besondere Maßnahmen zur Spannrahmenanpassung erforderlich sind.
Die Drähte können beliebig tief eingepreßt werden. Das Einpressen kann über die gesamte Drahtlänge oder auch nur stellenweise erfolgen.

Mit dem erfindungsgemäßen Verfahren ist es auch möglich, elektrisch isolierte Kreuzungen blanker Drähte in einer elektrisch isolierenden Schicht auszuführen.

Ein besonderer Vorteil der Erfindung besteht darin, dass Leiterdrahtanordnungen auch auf oder in Selbstklebeschichten angebracht werden können. Unter Selbstklebeschichten wird dabei eine auf einer Trageschicht aufgebrachte dünne Kleberschicht verstanden, die ohne weitere Nachbehandlung stark haftend bleibt. Die Selbstklebeschichten können falls erforderlich auch partiell elektrisch leitend sein.
Zur Beschichtung mittels Selbstklebeschicht kommen alle Materialien in Betracht, deren Oberflächen mit Selbstklebeschichten dauerhaft beschichtbar sind. Vorteilhaft sind elektrisch isolierende Oberflächen und elektrisch isolierende Selbstklebeschichten, jedoch sind sie nicht Bedingung. Die Dicke und Konsistenz der Selbstklebeschichten ist so zu wählen, dass in Abhängigkeit vom Leiterdrahtdurchmesser und der vorgegebenen Präzision der Übertragung des Leiterdrahtmusters mit dem/oder den elektronischen Bauelement(en), dass von den Leiterdrähten mindestens 10% der Mantelfläche sich in Klebekontakt mit der Selbstklebeschicht befinden und die elektronischen Bauelemente möglichst flächig auf der Selbstklebeschicht aufliegen.
Ist eine vollständige Einbettung der elektronischen Schaltung zwischen Materialoberflächen, z.B. zwischen zwei Papierschichten vorgesehen, ist es vorteilhaft die Dicke der elektronischen Bauelemente der Leiterdrahtstärke anzupassen und die Selbstklebeschicht so dick zu wählen, dass die gesamte elektronische Schaltung in die Selbstklebeschicht eingedrückt werden kann oder die Gesamtdicke der Selbstklebeschicht in eine Selbstklebeschicht zu unterteilen, in der die elektronische Schaltung fixiert wird und in eine Selbstklebeschicht, die auf das Deckmaterial aufgetragen ist. Das mit der Selbstklebeschicht versehene Deckmaterial ist auf die bereits fixierte elektronische Schaltung zu pressen, so dass die elektronische Schaltung beiderseits durch Selbstklebeschichten fixiert ist, wobei die Selbstkiebeschichten zum größeren Flächenteil untereinander verkleben.
So ist es möglich zwischen zwei selbstklebebeschichteten Papieren eine elektronische Schaltung (z.B. kontaktloser Transponder) vollständig einzubetten. Durch weitere Verfahrensschritte kann die Qualität und die Gestaltung entstandener eingebetteter elektronischer Schaltungen erhöht werden. Dies kann erfolgen durch:
1. Pressen vollständig eingebetteter Schaltungen, bei denen die Trageschichten aus Papier, Pappe, Thermoplasten (also plastischen Schichten) bestehen, zwischen planen Druckstempeln (ggf. mit Ausnahme des Flächenbereichs unter dem sich druck- oder bruchempfindliche elektrische Bauelemente befinden). Es ergeben sich damit völlig plane, ebene Schaltungen; die Leiterdrähte sind vollständig in die Klebeschichten eingepresst und z.T. in die Trageschichten gedrückt. Auf diese Weise können sehr dünne, sehr glatte elektronische Etiketten erzeugt werden.
2. Verpressen der Schaltung zwischen Formstempeln. Damit können dreidimensional gestaltete Schaltungen (beispielsweise für Designzwecke) hergestellt werden.
3. Zwei- oder dreidimensionales Verpressen bei gleichzeitigem Aushärten der Selbstklebeschicht und/oder Aushärten mindestens einer härtbaren Trageschicht, z.B. durch Licht oder durch geheizte Formstempel. Dadurch kann eine gute Stabilisierung auch schwieriger dreidimensionaler Verformungen bzw. Herstellung elastischer ebener, dünner eingebetteter elektronischer Schaltungen erzielt werden.

Soll das Leiterdrahtmuster netzartige oder flächendeckende Leiterdrahtelemente bilden, so ist es vorteilhaft sich kreuzende Leiterdrähte vor dem Eindrükken in die Selbstklebeschicht miteinander in Kreuzungsbereich zu kontaktieren (z.B. Thermokompressions-, elektrisches Widerstands oder Laserschweissen). Selbstverständlich können auch Leiterdrahtmuster ohne elektronische Bauelemente in die Selbstklebeschichten eingebettet werden, z.B. als Schirmebene gegen elektromagnetische Strahlungen.
Die Spannelemente sind in einem Spannrahmen angeordnet. Die Spannelemente (eckige oder runde Stifte) werden durch entsprechend dimensionierte Löcher geführt. Die Spannelemente sind an den Stellen angeordnet, an denen der Leiterdraht eine Richtungsänderung erfahren soll. Lassen sich die Spannelementeführungen, die auf Grund des Verschleißes vorzugsweise aus Metall bestehen, auf bestimmte Flächenbereiche der Schaltung konzentrieren, so kann der Spannrahmen aus elektrisch nichtleitendem Kunststoff bestehen, in den die Spannelementeführungen eingesetzt sind. Damit besteht die Möglichkeit, selbst kontaktlose elektronische Transponder nach dem Herstellen der Leiterdrahtmuster und nach dem Kontaktieren der elektronischen Bauelemente funktionell zu prüfen und ausschließlich funktionsfähige Transponder in die Selbstklebeschichten zu drücken.

Vorteilhaft ist dabei, dass sich mit einfachsten Mitteln (sehr kostengünstiger lackisolierter Draht wird zu Leiterdrahtmuster mit elektronischem Bauelement gestaltet, geprüft und auf selbstklebende Etikettenpapiere umgesetzt), bei minimalem Materialaufwand ohne Stütz- oder Hilfsfolien, Leiterplatten etc. und ohne technologisch bedingten Materialabfall sehr ökonomisch und ökologisch sehr dünne, formstabile und zuverlässige elektronische kontaktlose Transponder herstellen lassen.

Das Leiterdrahtmuster wird durch wickelähnliche Vorgänge auf dem Spannrahmen erstellt. Dazu wird für je einen Drahtdurchmesser das Drahtanfangstück durch Klemmen im Spannrahmen oder Anwickeln um einen im Spannrahmen etwas unterhalb der Drückebene eingesetzten scharfeckigen Wickelstift angewickelt, danach unter zur Spannrahmendrückebene paralleler Drahtführung der Draht unter Aufrechterhaltung einer bestimmten Zugspannung, um die Spannelemente, die etwa 0,3 ... 1,0 mm aus der Spannrahmendrückebene herausragen, so geschlungen und geführt, dass sich das beabsichtigte Leiterdrahtmuster ergibt. Unter Beibehaltung der Zugspannung wird das Leiterdrahtende im Spannrahmen geklemmt oder an einem scharfeckigen Stift angewickelt. Anschließend werden die zuvor oder nach dem Leiterdrahtmusterherstellen in den Spannrahmen eingelegten elektronischen Bauelemente mit dem Leiterdrahtmuster kontaktiert. Vorteilhaft ist es, im Leiterdraht die künftigen Kontaktstellen vorzuprägen (Flachdrücken) und eventuell Lackschichten zu entfernen. Dadurch wird eine einfachere und bessere Kontaktierung der elektronischen Bauelemente ermöglicht. Danach wird der Spannrahmen mit der Schaltung so auf die Selbstklebeschicht gedrückt, dass Leiterdraht und Bauelemente in bzw. auf der Selbstklebeschicht haften, gleichzeitig werden dabei die Spannelemente (Stifte) durch die Klebeschicht bzw. Tragschicht so zurückgedrückt, dass die Schaltung nur durch die Selbstklebeschicht fixiert wird.

Die Spannelemente sind während des Leiterdrahtmustererstellens so aus der Drückebene das Spannrahmens hervorzuheben, dass nur die Spannelemente hervorragen, die als nächste den Leiterdraht umlenken sollen. Dadurch ist gewährleistet, dass der Drahtmusterspannvorgang nicht durch unnötigerweise hervorstehende Spannelemente erschwert wird. Dabei kann es vorteilhaft sein, Spannelemente unterschiedlich weit (in Längenstufen) aus dem Spannrahmen ragen zu lassen.

Das Leiterdrahtmusterherstellen sollte vom Innenbereich des Spannrahmens nach außen verlaufend erfolgen.
Um zu vermeiden, dass die Stirnflächen der Spannelemente beim Absetzen/Eindrücken des Schaltungsmusters in die Selbstklebeschicht in dieser haften, ist es vorteilhaft, die Stirnflächen mit Silikonbeschichtung zu versehen und/oder die Stirnflächen periodisch zu befeuchten oder zu fetten.
Weiterhin ist es vorteilhaft, die Spannelemente mit einer Konizität zu versehen, um das Übergeben des Leiterdrahtmusters an die Selbstklebeschicht zu vereinfachen.

Die Spannelemente sind befestigt auf je einem Anschlag, der gegen die Unterseite des Spannrahmens drückt und verhindert, dass die Spannelemente weiter aus der Drückebene herausgedrückt werden können, als beabsichtigt ist. Unterhalb des Anschlages ist ein Distanzstück befestigt, welches die Länge des zur Druckplatte zeigenden gesamten Spannstückes festlegt. Die Spannstücke weisen damit differenzierte Längen auf Die Spannstücke werden durch eine unter ihrem Fußpunkt befindliche Druckplatte gehoben, so dass die Spannelemente über die Spannebene (Drückebene) des Spannrahmens ragen können.

Damit alle Spannstücke nacheinander, unabhängig von ihrer Gesamtlänge, von einer gemeinsamen Druckplatte angehoben und damit die Spannelemente nacheinander aus der Drückebene des Spannrahmens soweit herausgehoben werden können, bis der Anschlag auf der Spannrahmenunterseite aufliegt und das weitere Herausschieben des Spannelements verhindert, ist unterhalb der Distanzstücke der Spannstücke je ein vorgespanntes Druckfederstück angeordnet, mit einem Hub größer als der zu erwartende Arbeitshub der Druckplatte. Das Spannstück mit dem längsten Distanzstück wird von der Druckplatte zuerst angehoben. Bewegt sich die Druckplatte weiter in Richtung Spannrahmen, werden danach die Spannstücke mit den nächstkürzeren Distanzstücken angehoben u.s.w..
Die bereits mit dem Anschlag gegen die Unterseite des Spannrahmens drückenden Spannstücke federn nun im Druckfederstück ein.
Eine Vorspannung des Druckfederstückes gewährleistet, dass bei eventueller Reibung von Spannstück zur Spannstückfiihrung oder Spannelementführung das Spannstück wie ein starrer Stift wirkt und das Spannelement sicher aus dem Spannrahmen über die Drückebene herausgeschoben wird.

Die Erfindung wird im Folgenden anhand eines Ausführungsbeispieles näher erläutert.

In den zugehörigen Zeichnungen zeigen:
- Figur 1:: einen Spannrahmen mit einer elektronischen Schaltung in der Draufsicht,
- Figur 2:: Spannrahmen, Spannstück und Druckplatte im Querschnitt,
- Figur 3:: einen Querschnitt einer in einer Selbstklebeschicht zu fixierenden elektronischen Schaltung während des Eindrückens und
- Figur 4:: einen Querschnitt einer zwischen zwei Selbstklebeschichten auf papierartigen Trägern eingebetteten elektronischen Schaltung.

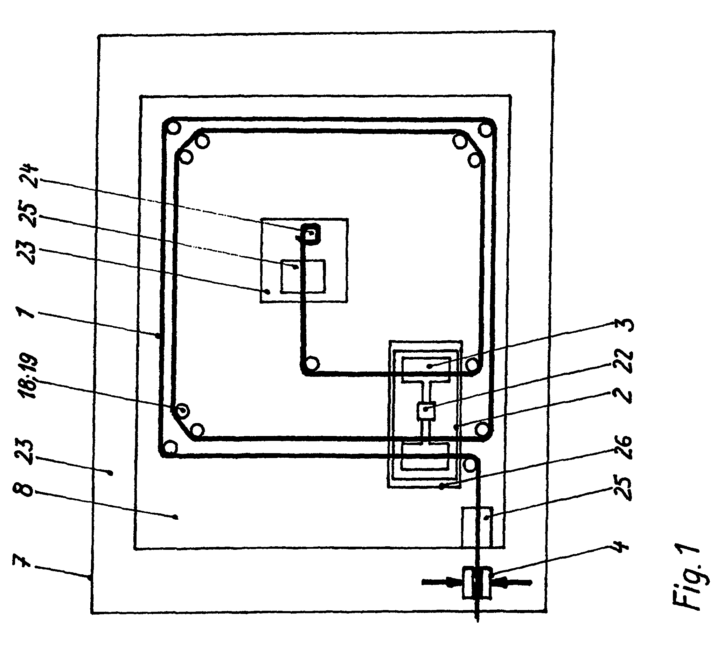

Der in Figur 1 dargestellte Spannrahmen 7 weist eine zentral angeordnete flächige Drückebene 8 und umlaufend einen etwas tiefer angeordneten rahmenförmigen Spannrahmenabsatz 23 auf Ebenfalls tiefer gelegt als die Drückebene 8 ist ein kleiner rechteckiger Spannrahmenabsatz 23, in dem ein Anwickelstift 24 platziert ist und in dem sich ein Durchgriffsloch 25 befindet. Ein weiteres Durchgriffsloch 25 ist zwischen Drahtklemme 4 und Spannelement 18, welches sich neben der Kontaktfläche 3 des folienartigen elektronischen Bauelements 2 befindet, angeordnet.
Die Durchgriffslöcher 25 dienen zum Durchführen von Messern und anderen Werkzeugen zum Trennen von Leiterdrähten 1 nach dem Fixieren der Schaltung in der Selbstklebeschicht 5.

Der Anfang des Leiterdrahtes 1 wurde mehrfach um den Anwickelstift 24 geschlungen, danach wurde der Leiterdraht 1 unter Beibehaltung einer auf den Leiterdrahtdurchmesser abgestimmten Zugspannung von innen nach außen führend, an den jeweils hervorstehenden rundstiftförmigen Spannelementen 18 richtungsändernd gezogen, schließlich in der Drahtklemme 4 geklemmt und danach abgetrennt.
An das so entstandene spulenförmige Leiterdrahtmuster wurde, von unten herangeführt durch den Durchbruch 26, das auf einer nicht näher bezeichneten Halterung befindliche folienartige elektronische Bauelement 2 so angebracht, dass die Kontaktflächen 3 direkt unterhalb der zur Kontaktierung vorgesehenen Leiterdrahtstücke 1 liegen. Anschließend erfolgte die Kontaktierung der Leiterdrahtstücke 1 mittels Thermokompression an die Kontaktflächen 3. Im Beispiel besteht der Leiterdraht 1 aus Kupfer, hat einen Durchmesser von 70 µm und ist mit einer dünnen Isolierlackschicht überzogen.
Das folienartige elektronische Bauelement 2 besteht aus einer 25 µm dicken Polyesterfolie, die im Beispiel 18 µm dicke Kupferleiterbahnen bzw. Kupferkontaktflächen 3 trägt. Im Flächenzentrum ist ein im Beispiel 90 µm dickes Halbleiterchip 22 mittels Flip-Chip-Technik kontaktiert.

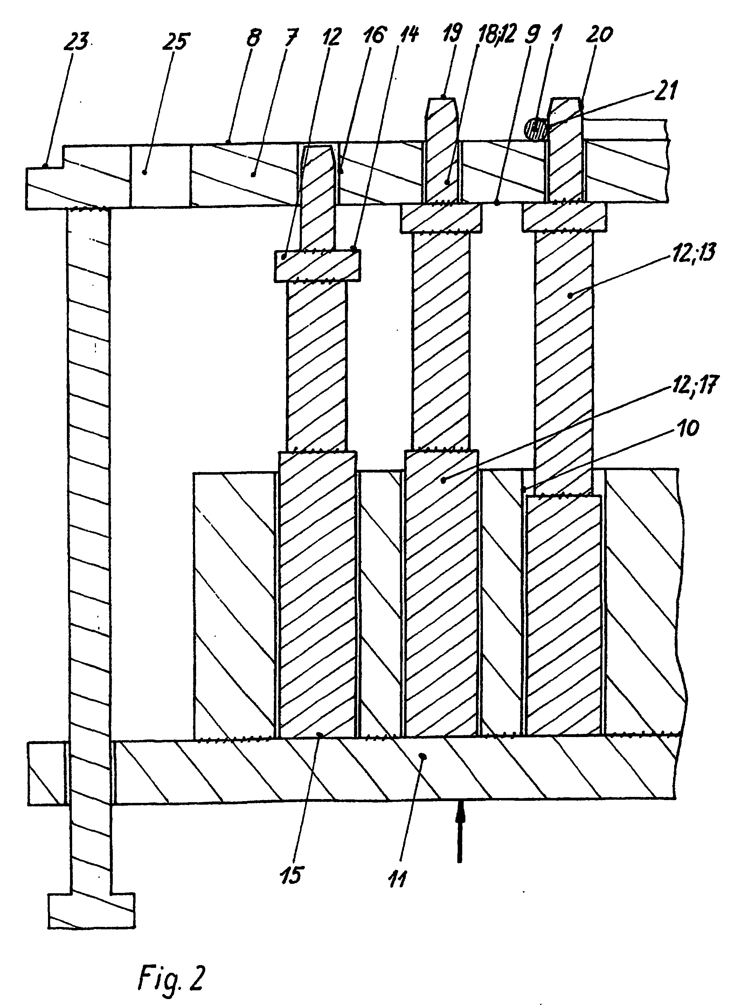

Figur 2 zeigt schematisch die Anordnung und Funktionsweise der Spannstücke 12 in der geschnittenen Seitenansicht.
Im oberen Teil der Figur 2 ist der Spannrahmen 7 angeordnet, dessen Oberseite die Drückebene 8 darstellt. An der Seite ist der Spannrahmenabsatz 23 erkennbar. Durch die bzw. in der Spannelementführung 16 des Spannrahmens 7 ragt das zylinderstinförmige Spannelement 18.
Das Spannelement 18 ist befestigt an einem Anschlag 14, der bei Anliegen an der Unterseite 9 des Spannrahmens 7 die über die Drückebene 8 herausstehende Länge des Spannelementes 18 begrenzt. Die Zylinderflächen des über die Drückebene 8 herausragenden Spannelementes 18 sind die Spannelementflächen 21, an denen der Leiterdraht 1 gespannt und umgelenkt wird.
Die Stirnfläche 19 des Spannelementes 18 drückt im Falle der Fixierung der elektronischen Schaltung in der Selbstklebeschicht 5 in diese hinein. Um ein unnötiges Haften des Spannelementes 18 in dieser Schicht 5 zu vermeiden, wird im Beispiel die Stirnfläche 19 mit Wasser angefeuchtet.
Zur Stirnfläche 19 hin ist das Spannelement 18 über im Beispiel eine Länge von 100 µm konisch gestaltet, um ein leichteres Abstreifen der gespannten Leiterdrähte 1 beim oder nach dem Eindrücken und Fixieren der Schaltung in der Selbstklebeschicht 5 zu erleichtern.

Der Anschlag 14 des Spannstückes 12 ist an seinem unteren Ende verbunden mit dem Distanzstück 13. Die Länge der Distanzstücke 13 ist gestuft in Abhängigkeit davon, zu welchem Zeitpunkt bzw. in welcher Reihenfolge die gegen die Fußpunkte 15 aller Spannstücke 12 drückende Druckplatte 11 die Spannelemente 18 durch die Drückebene 8 hindurchschieben soll. Die Spannelemente 18, im Beispiel die im inneren Flächenteil befindlichen Spannelemente 18, die den Leiterdraht 1 zu der inneren Spulenwindung aufspannen, müssen zuerst aus der Drückebene 8 ragen, deren Spannstücke 12 müssen entsprechend die längsten Distanzstücke 13 aufweisen.
Die Spannstücke 12, deren Spannelemente 18 als nächste durch die Drückebene 8 ragen sollen, müssen kürzer sein als die vorgenannten Spannstücke 12. Sollen die Spannelemente 18 um 0,5 mm aus der Drückebene herausragen, so sind die Längen der Distanzstücke 13 in (0,5 ... 0,6) mm - Stufen zu staffeln. Dem Distanzstück 13 schließt sich ein Druckfederstück 17 an. Dieses nimmt den weiteren Hub der Druckplatte 11 auf, wenn bereits der Anschlag 14 des Spannstückes 12 gegen die Unterseite 9 des Spannrahmens 7 drückt. Das Spannstück 12 insgesamt ist gerührt in einer nicht näher beschriebenen Spannstückführung 10, die im Beispiel direkt mit der Druckplatte 11 verbunden ist.

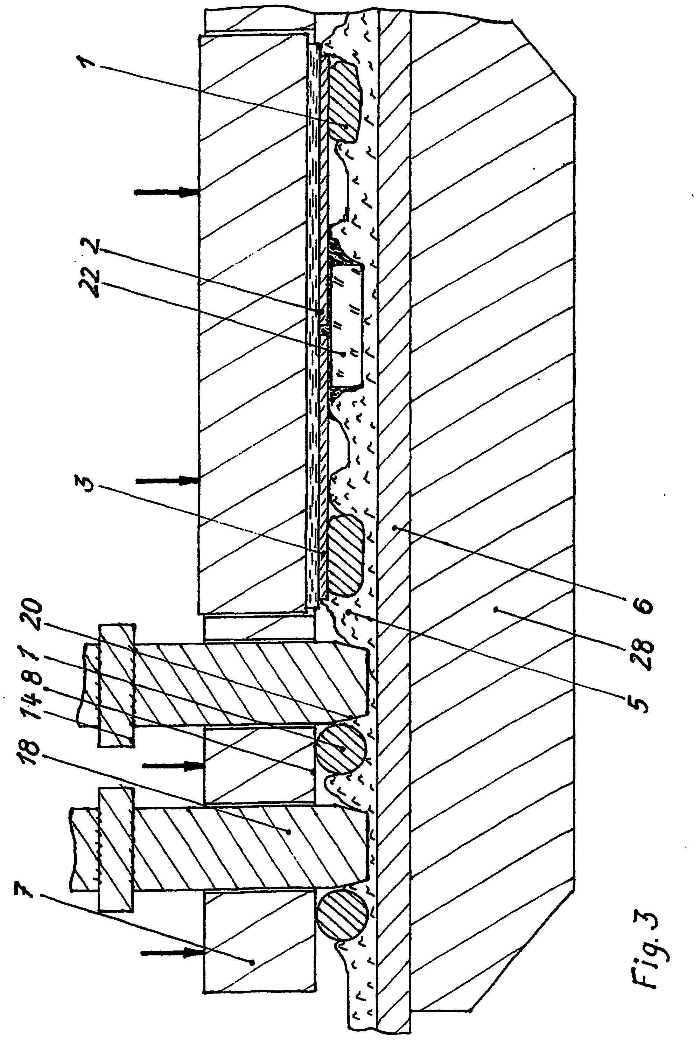

Figur 3 zeigt eine Seitenansicht der in der Selbstklebeschicht 5 zu fixierenden elektronischen Schaltung während des Eindrückens. Die Selbstklebeschicht 5 ca. 50 µm dick und befindet sich auf einem 100 µm dicken Kartonpapier als Trageschicht 6.

Die lackisolierten Leiterdrähte 1 werden zu ca. 50 % in die Selbstklebeschicht 5 eingedrückt. Das an die Leiterdrähte 1 kontaktierte filmartige elektronische Bauelement 2 ist mit seiner chiptragenden Leiterbahnseite bzw. Kontaktflächenseite 3 mit der Selbstklebeschicht 5 verbunden, das Halbleiterchip 22 ist etwa 40 µm tief in die Selbstklebeschicht 5 eingebettet. Die kontaktierten Leiterdrahtstücke 1 wurden vor dem Kontaktieren flachgepresst und abisoliert, um ein sicheren Kontaktiervorgang zu gewährleisten.
Figur 3 zeigt weiterhin, dass die Spannelemente 18 beim Eindrücken der elektronischen Schaltung in die Selbstklebeschicht 5 soweit zurückgeschoben werden, dass die Leiterdrähte 1 im Bereich der Konizität 20 der Spannelemente 18 liegen. Während des Eindrückens wird die Trageschicht 6 völlig eben von der ambossartigen Trageschichthalterung 28 gehalten. Das Zurückschieben der Spannelemente 18 in Richtung Drückebene 8 erfolgt durch Entlasten der Druckplatte 11 und durch Zurückdrücken der Spannelemente 18 durch die Trageschicht 6 und die Selbstklebeschicht 5 bei der Eindrückbewegung des Spannrahmens 7.

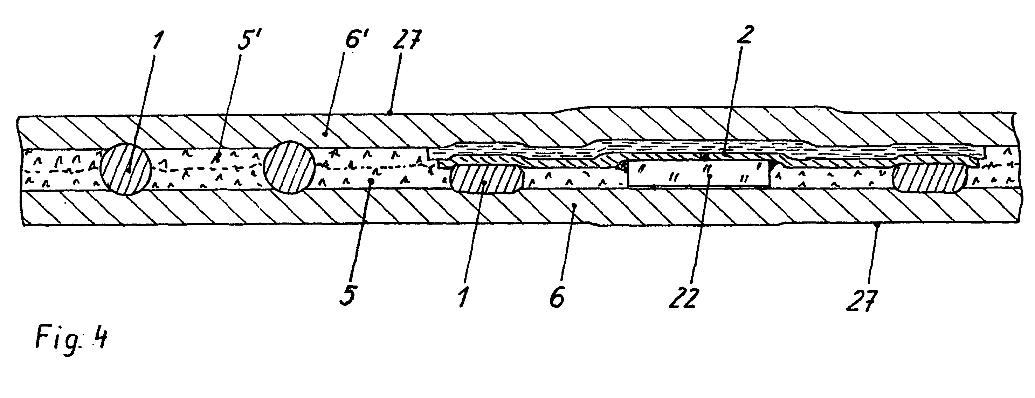

Figur 4 zeigt die gleiche elektronische Schaltung, die zuerst auf bzw. in einer Selbstklebeschicht 5' fixiert und danach mit einer zweiten Selbstklebeschicht 5 abgedeckt wurde. Die Trageschichten 6 und 6' bestehen aus jeweils 80 µm dickem Papier, deren Selbstklebeschichten 5 und 5' jeweils ca. (30 ... 60) µm dick sind. Nach dem vollständigen Einbetten der elektronischen Schaltung in die zwischen den beiden Trageschichten 6 und 6' befindlichen Selbstklebeschichten 5 und 5', ist das so entstandene Sandwichetikett 27 mittels planparallelen flächigen Druck-stempeln außer dem Flächenbereich über oder unter dem Halbleiterchip 22 so verpresst worden, dass die Gesamtdicke des Sandwichetikettes 27 auf ein Minimum reduziert wurde und beidseitig völlig ebene Trageschichten 6 und 6' entstehen.
Durch den Pressvorgang können je nach Wahl der Dicke der Selbstklebeschichten 5 und 5', der Leiterdrähte 1 und der elektronischen Bauelemente 2 die Leiterdrähte 1 und Teile der elektronischen Bauelemente 2 etwas in die Trageschichten 6 und 6' eingedrückt werden.
Es entstehen sehr dünne, sehr ebene und bedingt durch den mittig eingelegten Leiterdraht 1 sehr reiß- und biegefeste Tickets, Etiketten u.s.w.

### BEZUGSZEICHENLISTE

- 1: Leiterdraht
- 2: elektronisches Bauelement
- 3: Kontaktfläche des elektronischen Bauelementes
- 4: Drahtklemme
- 5, 5': Selbstklebeschicht
- 6, 6': Trageschicht
- 7: Spannrahmen
- 8: Drückebene
- 9: Unterseite
- 10: Spannstückführung
- 11: Druckplatte
- 12: Spannstück
- 13: Distanzstück
- 14: Anschlag
- 15: Fußpunkt/Fußfläche
- 16: Spannelementführung
- 17: Druckfederstück
- 18: Spannelement
- 19: Stirnfläche
- 20: Konizität
- 21: Spannelementfläche
- 22: Halbleiterchip
- 23: Spannrahmenabsatz
- 24: Anwickelstift
- 25: Durchgriffsloch
- 26: Durchbruch
- 27: Sandwichetikett, Sandwichlaminat
- 28: Trageschichthalterung

## Patentansprüche

1. Verfahren zum Anbringen von Leiterdrähten (1) auf oder in einer Trageschicht (6), bei dem eine zuvor außerhalb der Trageschicht (6) hergestellte Leiterdrahtanordnung anschließend in diese gedrückt wird, indem
- zunächst auf einem Spannrahmen (7) ein Muster aus Leiterdraht (1) aufgebracht wird, wobei
- der Leiterdraht (1) parallel oder nahezu parallel zur Drückebene (8) des Spannrahmens (7) über Spannelementflächen (21) einzelner Spannelemente (18) zu einem vorgegebenen Muster gespannt wird,
- danach das Leiterdrahtmuster in oder auf die Trageschicht (6) gedrückt und fixiert wird **dadurch gekennzeichnet,**
- **dass** beim Eindrücken des Leiterdrahtmusters in die Trageschicht (6) die Spannelemente (18) entsprechend der Eindrückbewegung zurückgleiten und das Leiterdrahtmuster freigeben, und, dass die axial verschiebbaren Spannelemente (8) nacheinander entsprechend der. herzustellenden Leiterdrahtanordnung aus der Drückebene (8) nacheinander vom Innenbereich der Leiterdrahtanordnung beginnend hervorgeschoben werden und so die Leiterdraht-Mustererzeugung durch einen Wickelvorgang erfolgt.

2. Verfahren nach Anspruch 1, **dadurch gekennzeichnet, dass** auf dem Spannrahmen (7) mit dem Leiterdraht (1) elektronische Bauelemente (2) kontaktiert und gemeinsam mit diesem in die Trageschicht (6) gedrückt werden.

3. Verfahren nach Anspruch 1 oder 2, **dadurch gekennzeichnet, dass** das Leiterdrahtmuster auf oder in eine auf der Trageschicht (6) befindliche Selbstklebeschicht (5) gedrückt wird.

4. Verfahren nach Anspruch 3, **dadurch gekennzeichnet, dass** auf die auf der Trageschicht (6) oder auf der Selbstklebeschicht (5) fixierte elektronische Schaltung, welche aus Leiterdrahtmuster und elektronischen Bauelementen (2) besteht, eine weitere Trageschicht (6') aufgedrückt wird, die mit der Selbstklebeschicht (5) haftend verbunden ist und die elektronische Schaltung vollständig bedeckt, wobei die weitere Trageschicht (6') eine weitere Selbstklebeschicht (5') aufweist und auf die Selbstklebeschicht (5) der ersten Trageschicht (6) so aufgebracht wird, dass die elektronische Schaltung in bzw. zwischen den Selbstklebeschichten (5, 5') und diese zwischen den Trageschichten (6,6) fixiert und geschützt ist.

5. Verfahren nach Anspruch 4, **dadurch gekennzeichnet, dass** die Dicke mindestens einer Selbstklebeschicht (5, 5') mindestens gleich dem Radius des Leiterdrahtes (1) ist.

6. Verfahren nach einem der vorhergehenden Ansprüche, **dadurch gekennzeichnet, dass** die Anordnung durch Prägepressen so behandelt wird, dass ein folienartiges, dünnes partiell oder insgesamt reliefartig geprägtes oder gefaltetes Sandwichlaminat (27) entsteht.

7. Verfahren nach Anspruch 6, **dadurch gekennzeichnet, dass** die Form des geprägten oder gefalteten Sandwichlaminates (27) durch lackartige und/oder imprägnierende und härtbare, auf die Tragschichten (6; 6') aufbringbare, pulverförmige oder flüssige Schichten stabilisiert wird.

8. Verfahren nach einem der vorhergehenden Ansprüche, **dadurch gekennzeichnet, dass** das Herausschieben der Spannelemente (18) aus der Drückebene (8) durch eine Druckplatte (11) erfolgt und die Spannelemente (18) über Distanzstücke (13) betätigt werden, wobei
- bei der Schiebebewegung der Druckplatte (11) in Richtung Spannrahmen (7) zuerst die Spannelemente (18) der Spannstücke (12) mit den längsten DistanzStücken (13) über die Drückebene (8) bis zum Anschlag (14) des Spannstückes (12) an die Unterseite (9) des Spannrahmens (7) geschoben werden,
- bei weiterer Schiebebewegung der Druckplatte (11) die Spannelemente (18) der Spannstücke (12) mit den nächst kürzeren Distanzstücken (13) aus der Drückebene (8) gehoben werden und wobei die Druckfederstücke (17) der bereits sich am Anschlag (14) befindlichen zuvor angehobenen Spannelemente (18) bzw. Spannstücke (12) zusammengedrückt werden usw.
- bis entsprechend der Schiebebewegung der Druckplatte (11) sich alle Spannelemente (18) über der Drückebene (8) befinden und alle Drückfederstücke (17) differenziert nach der Länge der Distanzstücke (13) eingefedert sind und
- dass durch wickelähnliche Vorgänge der Draht parallel zur Drückebene (8) entlang der jeweils nacheinander herausgedrückten Spannelemente (18) zum Leiterdrahtmuster gespannt wird.

9. Vorrichtung zur Durehführung des Verfahrens nach einem der vorhergehenden Ansprüche, wobei
- die Vorrichtung aus einer Trageschichthalterung (28) und einem mit einer Presse verbundenen Spannrahmen (7) besteht,
- wobei an dem Spannrahmen (7) eine Drückebene (8) und senkrecht oder nahezu senkrecht zur Drückebene (8) einzelne Spannelemente (18) angeordnet sind,
- dass die Trageschichthalterung (28) die Trageschicht (6) während des Eindrückens von Leiterdraht (1) und gegebenenfalls elektronischen Bauelement (2) fixiert und
- die Trageschichthalterung (28) parallel zur Drückebene (8) des Spannrahmens (7) liegt, **dadurch gekennzeichnet, dass** die Spannelemente (18) axial verschiebbar angeordnet sind.

10. Vorrichtung nach Anspruch 9, **dadurch gekennzeichnet, dass** die Spannelemente (18) Teil eines aus Spannelement (18), Anschlag (14), Distanzstück (13) und Druckfederstuck (17) bestehenden Spannstückes (12) sind.

11. Vorrichtung nach Anspruch 9 oder 10, **dadurch gekennzeichnet, dass** eine Druckplatte (11) unterhalb der Fußpunkte (15) der Spannstücke (12) angeordnet ist, die durch Verschiebung zum Spannrahmen (7) alle Spannstücke (12) axial zum Spannrahmen (7) verschiebt:

12. Vorrichtung nach einem der Ansprüche 10 oder 11, **dadurch gekennzeichnet, dass** die Gesamtlänge der einzelnen Spannstücke (12) durch die Länge der Distanzstücke (13) festgelegt ist.

13. Vorrichtung nach einem der Ansprüche 10 bis 12, **dadurch gekennzeichnet, dass** die einzelnen Spannstücke (12) stufenweise differenzierte Gesamtlängen aufweisen.

14. Vorrichtung nach einem der Ansprüche 12 oder 13, **dadurch gekennzeichnet, dass** die jeweiligen Stufenlängen der Distanzstücke (13) gleich größer sind als die über die Drückebene (8) maximal ragenden Spannelementlängen.

15. Vorrichtung nach einem der Ansprüche 9 bis 14, **dadurch gekennzeichnet, dass** die Spannelemente (18) mit Anschlägen (14) versehen sind, die das Herausschieben der Spannelemente (18) aus der Drückebene (8) begrenzen.

## Claims

1. Procedure for fitting conductor wires (1) on or in a substrate (6), with a conductor wire arrangement created outside the substrate (6) beforehand is subsequently pressed into that substrate by:
- first applying a pattern of conductor wire (1) on a tensioning frame (7) with
- the conductor wire (1) being tightened in parallel or almost in parallel to the pressing plane (8) of the tensioning frame (7) via tensioning element surfaces (21) of single tensioning elements (18) to a predefined pattern,
- the conductor wire pattern being subsequently pressed and fixed in or on the substrate (6), **characterized in that**
- during the pressing-in of the conductor wire pattern into the substrate (6), the tensioning elements (18) slide back according to the pressing-in movement and release the conductor wire pattern, and
**in that** the axially movable tensioning elements (8) are pushed forward one after the other according to the conductor wire arrangement to be created from the pressing plane (8) one after the other starting from the inside part of the conductor wire arrangement, thus creating the conductor wire pattern arrangement by a winding process.

2. Procedure as claimed in claim 1, **characterized in that** electronic components (2) are contacted on the tensioning frame (7) with the conductor wire (1), and are pressed into the substrate (6) together with it.

3. Procedure as claimed in claims 1 or 2, **characterized in that** the conductor wire pattern is pressed on or in a self-adhesive layer (5) located on the substrate (6).

4. Procedure as claimed in claim 3, **characterized in that**, on top of the electronic circuit fixed on the substrate (6) or on the self-adhesive layer (5), and consisting of conductor wire pattern and electronic components (2), an additional substrate (6') is pressed on and bonded by adhesion to the self-adhesive layer (5), and completely covers the electronic circuit, while the additional substrate (6') presents an additional self-adhesive layer (5'), and is placed on the self-adhesive layer (5) of the first substrate (6) such that the electronic circuit is fixed in place and protected in or, respectively, between the self-adhesive layers (5, 5') and this is fixed and protected in or between the substrates (6, 6').

5. Procedure as claimed in claim 4, **characterized in that** the thickness of at least one self-adhesive layer (5, 5') is at least equal to the radius of the conductor wire (1).

6. Procedure according to any foregoing claim, **characterized in that** the arrangement is treated by stamping pressing such as to achieve a film-like thin sandwich laminate (27) partially or wholly embossed in relief or folded.

7. Procedure as claimed in claim 6, **characterized in that** the shape of the embossed or folded sandwich laminate (27) is stabilized by powdery or liquid enamel-like and/or impregnating and hardenable layers applicable to the substrates (6; 6').

8. Procedure as claimed in any foregoing claim, **characterized in that** the pushing-out of the tensioning elements (18) from the pressing plane (8) is brought about by a pressure plate (11) and that the tensioning elements (18) are actuated via spacing pieces (13) while
- during the pushing movement of the pressure plate (11) in the direction of the tensioning frame (7), the tensioning elements (18) of the tensioning pieces (12) with the longest spacing pieces (13) are first pushed via the pressing plane (8) to the limit stop (14) of the tensioning piece (12) to the bottom side (9) of the tensioning frame (7);
- during the further pushing movement of the pressure plate (11), the tensioning elements (18) of the tensioning pieces (12) with the next shorter spacing pieces (13) are lifted out of the pressing plane (8), and, while compression is exerted on the compression spring pieces (17) of the tensioning elements (18) or tensioning pieces (12) already located at the limit stop (14) and lifted up before, etc.,
- until all tensioning elements (18) are above the pressing plane (8) according to the pushing movement of the pressure plate (11), and all compression spring pieces (17) are spring-located, being differentiated according to the length of the spacing pieces (13), and
- **in that** the wire is tightened by wrap-like processes in parallel to the pressing plane (8) along the tensioning elements (18) pressed out each one after the other to the conductor wire pattern.

9. Device for performing the procedure as claimed in any of the foregoing claims, wherein
- the device consists of a substrate holder (28) and a tensioning frame (7) connected with a press;
- while a pressing plane (8) is located at the tensioning frame (7), and while single tensioning elements (18) are located perpendicularly or almost perpendicularly to the pressing plane (8);
- that the substrate holder (28) fixes the substrate (6) during the pressing-in of conductor wire (1) and of electronic components (2), if any; and
- that the substrate holder (28) is located in parallel to the pressing plane (8) of the tensioning frame (7), **characterized in that** the tensioning elements (18) are located such that they can be shifted axially.

10. Device as claimed in claim 9, **characterized in that** the tensioning elements (18) are part of a tensioning piece (12) consisting of tensioning element (18), limit stop (14), spacing piece (13) and compression spring piece (17).

11. Device as claimed in claims 9 or 10, **characterized in that** a pressure plate (11) is located below the foot points (15) of the tensioning pieces (12), and displaces all tensioning pieces (12) axially to the tensioning frame (7) by shifting to the tensioning frame (7).

12. Device as claimed in any claims 10 or 11, **characterized in that** the total length of every tensioning piece (12) is defined by the length of the spacing pieces (13).

13. Device as claimed in any claims 10 to 12 **characterized in that** the individual tensioning pieces (12) present total lengths which are differentiated stepwise.

14. Device as claimed in any claims 12 or 13, **characterized in that** the corresponding step lengths of the spacing pieces (13) are equal to or greater than the tensioning element lengths extending at maximum over the pressing plane (8).

15. Device as claimed in any claims 9 to 14, **characterized in that** the tensioning elements (18) are provided with limit stops (14) which limit the pushing-out of the tensioning elements (18) out of the pressing plane (8).

## Revendications

1. Procédé pour l'application de fils métalliques conducteurs (1) sur ou dans une couche-support (6), où une structure en fil métallique conducteur précédemment fabriquée à l'extérieur de la couche-support (6) est ensuite empreinte dans celle-ci, par
- première application d'un motif de fil métallique conducteur (1) sur un cadre de serrage (7)
- serrage du fil métallique conducteur (1) selon un motif défini parallèlement ou presque parallèlement au niveau de pression (8) du cadre de serrage (7) par des surfaces (21) de différents éléments de serrage (18),
- pression et fixation finales du motif de fil métallique conducteur sur ou dans la couche-support (6)
**caractérisé en ce que**
- à l'empreinte du motif de fil métallique conducteur dans la couche-support (6), les éléments de serrage (18) coulissent en retrait en fonction du mouvement de pression et libèrent le motif de fil métallique conducteur, et
que les éléments de serrage axialement déplaçables (8) sont successivement repoussés du niveau de pression (8) en fonction de la structure en fil métallique conducteur à générer, en partant de l'intérieur de la structure en fil métallique conducteur, en générant ainsi le motif de fil métallique conducteur par phénomène d'enroulement.

2. Procédé selon la revendication 1, **caractérisé en ce que** des composants électroniques (2) sont contactés par le fil métallique conducteur (1) sur le cadre de serrage (7) et empreints dans la couche-support (6) avec celui-ci.

3. Procédé selon la revendication 1 ou 2, **caractérisé en ce que** le motif de fil métallique conducteur est empreint sur ou dans une couche autocollante (5) disposée sur la couche-support (6).

4. Procédé selon la revendication 3, **caractérisé en ce qu'**une autre couche-support (6') est empreinte sur le circuit électronique fixé sur la couche-support (6) ou sur la couche autocollante (5), laquelle consiste en un motif de fil métallique conducteur et en des composants électroniques (2), est adhérente à la couche autocollante (5), recouvre intégralement le circuit électronique, et présente une autre couche autocollante (5'), et **en ce que** ladite autre couche-support (6') est appliquée sur la couche autocollante (5) de la première couche-support (6) de manière à fixer et protéger le circuit électronique dans ou entre les couches autocollantes (5, 5'), et celles-ci entre les couches-support (6,6').

5. Procédé selon la revendication 4, **caractérisé en ce que** l'épaisseur d'au moins une couche autocollante (5, 5') est au moins égale au rayon du fil métallique conducteur (1).

6. Procédé selon l'un des revendications précédentes, **caractérisé en ce que** la structure est traitée par empreinte de manière à produire un stratifié sandwich (27) mince en forme de feuille, partiellement ou intégralement gaufré ou plié en relief.

7. Procédé selon la revendication 6, **caractérisé en ce que** la forme du stratifié sandwich gaufré ou plié (27) est stabilisée par des couches poudreuses ou liquides de type vernis et/ou imprégnantes et durcissables, applicables sur les couches-support (6; 6').

8. Procédé selon l'un des revendications précédentes, **caractérisé en ce que** le repoussement des éléments de serrage (18) hors du niveau de pression (8) est obtenu par une plaque de pression (11) et **en ce que** les éléments de serrage (18) sont actionnés par des pièces d'écartement (13),
- le mouvement de poussée de la plaque de pression (11) vers le cadre de serrage (7) repoussant d'abord les éléments de serrage (18) des pièces de serrage (12) avec les pièces d'écartement (13) les plus longues (13) au-dessus du niveau de pression (8) jusqu'à la butée (14) de la pièce de serrage (12) sur la face inférieure (9) du cadre de serrage (7),
- le mouvement de poussée de la plaque de pression (11) étant poursuivi, les éléments de serrage (18) des pièces de serrage (12) sont soulevés du niveau de pression (8) avec les pièces d'écartement (13) immédiatement plus courtes (13), les ressort de pression (17) des éléments de serrage (18) ou pièces de serrage (12) précédemment soulevés et se trouvant déjà contre la butée (14) étant comprimés, et ainsi de suite
- jusqu'à ce qu'en fonction du mouvement de poussée de la plaque de pression (11), tous les éléments de serrage (18) se retrouvent au-dessus du niveau de pression (8), et que tous les ressorts de pression (17) soient différemment comprimés en fonction de la longueur des pièces d'écartement (13)
et
- **en ce que** par phénomènes analogues à des enroulements, le fil métallique est serré sur le motif de fil métallique conducteur parallèlement au niveau de pression (8) le long des différents éléments de serrage (18)successivement pressés.

9. Dispositif pour l'exécution du procédé selon l'une des revendications précédentes, où
- le dispositif se compose d'une fixation de couche-support (28) et d'un cadre de serrage (7) relié à une presse,
- un niveau de pression (8) étant disposé contre le cadre de serrage (7), ainsi que différents éléments de serrage (18) perpendiculaires ou presque perpendiculaires au niveau de pression (8),
- en ce que la fixation de couche-support (28) fixe la couche-support (6) pendant l'empreinte du fil métallique conducteur (1) et du composant électronique (2) le cas échéant, et
- que la fixation de couche-support (28) repose parallèlement au niveau de pression (8) du cadre de serrage (7), **caractérisé en ce que** les éléments de serrage (18) sont déplaçables axialement.

10. Procédé selon la revendication 9, **caractérisé en ce que** les éléments de serrage (18) font partie d'une pièce de serrage (12) composée de l'élément de serrage (18), de la butée (14), de la pièce d'écartement (13) et du ressort de pression (17).

11. Procédé selon la revendication 9 ou 10, **caractérisé en ce qu**'une plaque de pression (11) est disposée sous les bases (15) des pièces de serrage (12), laquelle déplace toutes les pièces de serrage (12) axialement vers le cadre de serrage (7) par poussée sur le cadre de serrage (7).

12. Procédé selon l'une des revendications 10 ou 11, **caractérisé en ce que** la longueur totale des différentes pièces de serrage (12) est déterminée par la longueur des pièces d'écartement (13).

13. Procédé selon l'une des revendications 10 à 12, **caractérisé en ce que** les différentes pièces de serrage (12) présentent des longueurs totales échelonnées.

14. Procédé selon l'une des revendications 12 ou 13, **caractérisé en ce que** les différentes longueurs échelonnées des pièces d'écartement (13) sont égales ou supérieures à celles des éléments de serrage faisant saillie maximale au-dessus du niveau de pression (8).

15. Procédé selon l'une des revendications 9 à 14, **caractérisé en ce que** les éléments de serrage (18) sont pourvus de butées (14) limitant le repoussement des éléments de serrage (18) hors du niveau de pression (8).
